# EUROPÄISCHE PATENTSCHRIFT

(11) **EP 3 478 865 B1**
(45) Veröffentlichungstag und Bekanntmachung des Hinweises auf die Patenterteilung: **24.06.2020**
(21) Anmeldenummer: 17749366.5
(22) Anmeldetag: 30.06.2017
(51) Int. Cl.: C22C 13/00, H01L 35/14, C22C 19/00, C22C 19/03, C22C 30/04, C22F 1/00

(54) **THERMOELEKTRISCHER GEGENSTAND UND VERBUNDMATERIAL FÜR EINE THERMOELEKTRISCHE UMWANDLUNGSVORRICHTUNG SOWIE VERFAHREN ZUM HERSTELLEN EINES THERMOELEKTRISCHEN GEGENSTANDS**
THERMOELECTRIC ARTICLE, COMPOSITE MATERIAL FOR A THERMOELECTRIC CONVERSION DEVICE, AND METHOD FOR PRODUCING A THERMOELECTRIC ARTICLE
OBJET THERMOÉLECTRIQUE ET MATÉRIAU COMPOSITE DESTINÉ À UN DISPOSITIF DE CONVERSION THERMOÉLECTRIQUE, AINSI QUE PROCÉDÉ DE FABRICATION D'UN OBJET THERMOÉLECTRIQUE

(30) Priorität: 30.06.2016 DE 102016211877
(43) Veröffentlichungstag der Anmeldung: 08.05.2019
(73) Patentinhaber: Vacuumschmelze GmbH & Co. KG, 63450 Hanau (DE)
(72) Erfinder: BRACCHI, Alberto, 63457 Hanau (DE); MÜLLER, Michael, 63939 Wörth (DE)
(74) Vertreter: Moore, Joanne Camilla
(86) Internationale Anmeldenummer: PCT/EP2017/025190
(87) Internationale Veröffentlichungsnummer: WO 2018/001574

(56) Entgegenhaltungen:
- US-A1- 2015 122 302
- CHAI YAW WANG ET AL: "The effect of an isoelectronic Ti-Zr substitution on Heusler nanoprecipitation and the thermoelectric properties of a (Ti0.2,Zr0.8)Ni1.1Sn half-Heusler alloy", JOURNAL OF ALLOYS AND COMPOUNDS, ELSEVIER SEQUOIA, LAUSANNE, CH, Bd. 662, 15. Dezember 2015 (2015-12-15), Seiten 566-577, XP029385644, ISSN: 0925-8388, DOI: 10.1016/J.JALLCOM.2015.12.098
- SHUTOH N ET AL: "THERMOELECTRIC PROPERTIES OF THE TIX(ZR0.5HF0.5)1-XNISN HALF-HEUSLER COMPOUNDS", THERMOELECTRICS, 2003 TWENTY-SECOND INTERNATIONAL CONFERENCE ON - ICT LA GRANDE MOTTE, FRANCE AUG. 17-21, 2, PISCATAWAY, NJ, USA,IEEE, 1. Januar 2003 (2003-01-01), Seiten 312-315, XP008064313, ISBN: 978-0-7803-8301-2

## Beschreibung

Die Erfindung betrifft einen thermoelektrischen Gegenstand für eine thermoelektrische Umwandlungsvorrichtung, ein Verbundmaterial für eine thermoelektrische Umwandlungsvorrichtung sowie ein Verfahren zum Herstellen eines thermoelektrischen Gegenstands für eine thermoelektrische Umwandlungsvorrichtung. Insbesondere betrifft die Erfindung thermoelektrische Materialien auf Basis der Halb-Heusler-Verbindungen.

Thermoelektrische Effekte erlauben die direkte Umwandlung von thermischer Energie in elektrische Energie und umgekehrt. Je nach Anwendung unterscheidet man dabei zwischen dem Seebeck-Effekt und dem Peltier-Effekt.

Der Peltier-Effekt beschreibt, dass ein elektrischer Strom in einem Material mit einem Wärmestrom verbunden ist. Das Verhältnis von Wärmestrom zu elektrischem Strom wird als Peltier-Koeffizient bezeichnet. In einem geschlossenen Stromkreis aus zwei Leitern mit unterschiedlichen Peltier-Koeffizienten ist die Wärmebilanz an den Kontakten nicht ausgeglichen und es kommt zum Aufheizen eines Kontaktes, während der andere Kontakt gekühlt wird.

Der Seebeck-Effekt hingegen besagt, dass eine Temperaturdifferenz zwischen zwei Enden eines Materials zum Ausbilden einer zur Temperaturdifferenz proportionalen elektrischen Spannung führt. Das Verhältnis von Spannung zu Temperaturdifferenz wird als Seebeck-Koeffizient S bezeichnet.

Technische Anwendung finden die thermoelektrischen Effekte beispielsweise in Thermoelementen zur Temperaturmessung, thermoelektrischen Modulen (TE-Modulen) zum Kühlen bzw. Heizen und in thermoelektrischen Modulen zur Erzeugung elektrischen Stroms. Thermoelektrische Module zum Kühlen bzw. Heizen werden auch als Peltier-Module bezeichnet, während Module zur Stromerzeugung auch als thermoelektrische Generatoren (TEGs) bezeichnet werden.

Halb-Heusler-Verbindungen sind intermetallische Verbindungen der allgemeinen Formel αβχ, die eine geordnete kubische C1_{b} Kristallstruktur aufweisen. Ein Übergangsmetall α, ein Übergangsmetall β und ein Hauptgruppen-Metall χ besetzen jeweils eines von drei ineinander geschachtelten kubisch flächenzentrierten (kfz) Untergittern. Ein viertes kfz Untergitter ist unbesetzt. Beträgt die Summe der Valenzelektronen in dieser Struktur 18, so zeigen die Verbindungen ein halbleitendes Verhalten mit einer Energielücke von 0 bis 1 eV. Somit sind sie als effiziente thermoelektrische Materialien für einen mittleren Temperaturbereich von ungefähr 400 °C bis 600 °C besonders geeignet.

Die Effizienz der Materialien wird durch die thermoelektrische Gütezahl *ZT* beschrieben, welche durch *ZT* = *TS*²*σ*/*κ* definiert ist. Dabei ist *T* die absolute Temperatur, *S* der Seebeck-Koeffizient, *σ*-die elektrische Leitfähigkeit und *κ* die Wärmeleitfähigkeit. Neben dem ZT-Wert wird zum Vergleich verschiedener thermoelektrischer Materialien auch oft der Power-Faktor *PF* verwendet, welcher sich aus *PF* = *S²σ* berechnet.

Gute n-typ thermoelektrische Halb-Heusler-Verbindungen sind im System αNiSn (α = Zr, Hf, Ti) bekannt. Durch Substitutionen auf den verschiedenen Untergittern konnten hier thermoelektrische Materialien mit hohen ZT-Werten entwickelt werden. Isoelektronische Substitution auf dem α-Gitterplatz mittels Ti, Zr und Hf zur Verringerung der Wärmeleitfähigkeit und die Dotierung auf dem Sn-Gitterplatz mittels des Donators Sb zur Erhöhung der elektrischen Leitfähigkeit sind beispielsweise in der US 2010/0147352 A1 und US2005/0172994 A1 offenbart.

Ein Nachteil der Verbindungen auf Basis von αNiSn ist, dass zur Erlangung eines hohen *ZT-*Werts ein hoher Anteil von Hafnium auf dem α-Gitterplatz notwendig ist. Da derzeit Hafnium als Rohstoff sehr teuer ist, wäre es wünschenswert, den Hf-Gehalt zu reduzieren.

Die US 2010/0147352 A1 und die US 2005/0172994 A1 offenbaren neben der isoelektronischen Substitution auch die Substitution des α-Gitterplatzes mittels Akzeptor- oder Donatorelementen aus den Nebengruppen 3 (Sc, Y, La) und 5 (V, Nb, Ta) zur Verbesserung der thermoelektrischen Eigenschaften des Systems αNiSn. Die Bildung von Fremdphasen durch einen zu hohen Anteil dieser Elemente ist dabei zu vermeiden. Allgemein können diese Verbindungen mit der Summenformel A*ₓ*B*_{y}*α_{1-*x*-*y*}Niχ beschrieben werden. Dabei sind A eines oder mehrere der p-dotierenden Akzeptor-Elemente Sc, Y, La; B eines oder mehrere der n-dotierenden Donator-Elemente V, Nb, Ta; α Ti, Zr oder Hf und χ eines oder beide der Elemente Sn oder Sb.

In US 2005/0172994 A1 werden Beispiele für die Substitution der Akzeptor- und Donator-Elemente ohne die Bildung von Fremdphasen in Halb-Heusler Verbindungen mit α=Ti_{0,3}Zr_{0,35}Hf_{0,35} und α=Ti_{0,5}Zr_{0,25}Hf_{0,25} demonstriert. Die US 2010/0147352 A1 behandelt dagegen Hf-reduzierte Halb-Heusler Phasen, bei denen der Anteil von Hf auf dem α-Gitterplatz auf kleiner 1% beschränkt wird. Die Substitution der Akzeptor- und Donator-Elemente ohne die Bildung von Fremdphasen wird in Halb-Heusler Verbindungen mit α=Ti und α=Zr demonstriert. In diesen Hf-reduzierten Halb-Heusler Verbindungen wurden ZT-Werte bis maximal 0,7 erreicht.

Eine Halb-Heusler-Verbindung ist auch im Artikel Chai Yaw Wang et al "The effect of an isoelectronic Ti-Zr substitution on Heusler nanopreceipitation and the thermoelectric properties of a (Ti0.2, Zr0.8)Ni1.1Sn half-heusler Alloy", J. Alloys and Compounds, 662, Seiten 566-577, 2015 offenbart.

Aufgabe der Erfindung ist es daher, ein n-Typ thermoelektrisches Material bereitzustellen, bei dem der Anteil an Hafnium reduziert ist und das gleichzeitig einen hohen ZT-Wert besitzt.

Erfindungsgemäß wird ein thermoelektrischer Gegenstand für eine thermoelektrische Umwandlungsvorrichtung mit einer Gesamtzusammensetzung bestehend aus
6 Atom-% ≤ Ti ≤ 27 Atom-%,
6 Atom-% ≤ Zr ≤ 27 Atom-%,
0 Atom-% ≤ Hf ≤ 1,7 Atom-%, wobei 28 Atom-% ≤ (Ti + Zr + Hf) ≤ 38 Atom-% ist,
28 Atom-% ≤ Sn ≤ 38 Atom-%,
0 Atom-% ≤ Sb ≤ 3 Atom-%, wobei 28 Atom-% ≤ (Sn + Sb) ≤ 38 Atom-% ist,
0 Atom-% ≤ A ≤ 7 Atom-%,
0 Atom-% ≤ B ≤ 7 Atom-%, wobei A eines oder mehrere der Elemente ausgewählt aus der Gruppe bestehend aus Sc, Y und La ist, B eines oder mehrere der Elemente ausgewählt aus der Gruppe bestehend aus V, Nb und Ta ist, und 0,15 Atom-% ≤ A+B ≤ 7 Atom-% ist,
Rest Ni sowie bis zu 5 Atom-% Verunreinigungen,
bereitgestellt.

Mit dieser Gesamtzusammensetzung wird eine Halb-Heusler-Verbindung erstrebt, die sowohl Ti als auch Zr aufweist, insbesondere sollte sie zumindest 6 Atom-% Ti und 6 Atom-% Zr aufweisen. Eines oder beide der Elemente Ti und Zr der Halb-Heusler Phase kann teilweise mit Hf ersetzt werden kann, wobei der Anteil an Hf in der Summe (Ti+Zr+Hf) auf dem α Gitterplatz ≤ 5 Atom-% beträgt. Diese Gesamtzusammensetzung weist einen niedrigen Hf-Gehalt von weniger als 1,7 Atom-% auf, sodass durch den reduzierten Hf-Gehalt die Rohstoffkosten für das thermoelektrische Material verringert werden, was einen ökonomischen Einsatz der Materialien zur thermoelektrischen Umwandlung ermöglicht. Gleichzeitig weist der thermoelektrische Gegenstand gute thermoelektrische Eigenschaften wie einen hohen ZT-Wert auf.

Der Hafnium-Gehalt kann ausschließlich oder teilweise durch einen vorhandenen Anteil an Hf in der Zirkoniumquelle bereitgestellt werden. Zum Beispiel kann das Zirkonium zwischen 0,5 Atom-% und 3 Atom-% Hf als Begleitelement aufweisen. Folglich ist die Gesamtzusammensetzung nicht Hf-frei, obwohl Hf nicht gezielt in der Zusammensetzung zugefügt wird. Falls der Anteil an Hf in der Zirkoniumquelle zu niedrig ist, kann der Hafniumgehalt durch die Verwendung einer weiteren getrennten Hafniumquelle erhöht werden. Im hergestellten thermoelektrischen Gegenstand kann das Hafnium am Gitterplatz anstelle von Zirkonium oder Titan angeordnet sein.

Die Gesamtzusammensetzung des thermoelektrischen Gegenstands kann auch durch die Formel AₓB_{y}Tiₐ₁Zrₐ₂Hfₐ₃NiSn_{c}Sb_{b} beschrieben werden, wobei 0 ≤ x ≤ 0,2, 0 ≤ y ≤ 0,2, 0,005 ≤ (x+y) ≤ 0,2, 0,2 ≤ a1 ≤ 0,8, 0,2 ≤ a2 ≤ 0,8, 0 ≤ a3 ≤ 0,05, 0,9 ≤ (a1 +a2+a3) ≤ 1,1, 0 ≤ b ≤ 0,1 und 0,9 ≤(b+c) ≤ 1,1 ist. Der Gehalt an den Elementen A und B kann gleich sein, sodass x = y in der oben genannten Schreibweise ist, oder unterschiedlich, sodass x ≠ y.

Unter Verunreinigungen werden Elemente bezeichnet, die nicht gezielt in der Gesamtzusammensetzung zugefügt werden, oder die durch das Herstellungsverfahren bedingt sind. Die Verunreinigungen können eines oder mehrere Elemente der Gruppe bestehend aus O, C, N, Al, Fe aufweisen. Der maximale Gehalt an den einzelnen Elementen kann O ≤ 4 Atom-%, C ≤ 1 Atom-%, N ≤ 0,5 Atom-%, Al ≤ 2 Atom-% und Fe ≤ 2 Atom-% sein, wobei der maximale Gesamtgehalt an Verunreinigungen bis zu 5 Atom.-% sein kann.

Ein thermoelektrischer Gegenstand mit der erfindungsgemäßen Gesamtzusammensetzung weist sehr gute thermoelektrische Eigenschaften auf. In einem Ausführungsbeispiel weist der thermoelektrische Gegenstand ein Maximum der thermoelektrischen Gütezahl ZTₘₐₓ von ≥ 0,8 vorzugsweise ≥ 0,9 auf, wobei 400°C ≤ Tₘₐₓ ≤ 700°C sein kann, und/oder einen Seebeck-Koeffizienten S, wobei - 350 (µV/K) ≤ S ≤- 80 (µV/K) ist, und/oder ein Maximum des Power-Faktors PFₘₐₓ von >3,5 (mW m⁻¹ K-²) auf.

Der thermoelektrische Gegenstand kann mehrere Phasen aufweisen, sodass die Zusammensetzung der einzelnen Phasen von der Gesamtzusammensetzung abweicht. Insbesondere kann der thermoelektrische Gegenstand mindestens 90 Vol-% zumindest einer Phase mit einer Halb-Heusler-Struktur aufweisen. Diese Halb-Heusler-Verbindung kann zumindest 6 Atom-% Ti und 6 Atom-% Zr aufweisen. Der restliche Anteil des thermoelektrischen Gegenstands kann aus A-reichen und B-reichen Phasen gebildet sein. Die eine oder mehreren A-reichen-Phasen können keine Halb-Heusler-Struktur und die eine oder mehreren B-reichen Phasen keine Halb-Heusler-Struktur aufweisen. Diese A-reichen Phasen und B-reichen-Phasen können die Form von Einschlüssen oder Ausscheidungen aufweisen, die in einer Matrix mit einer Halb-Heusler-Struktur vorhanden sind. Trotz dieser weiteren A-reichen und B-reichen Phasen ohne eine Halb-Heusler-Struktur werden gute thermoelektrische Eigenschaften bereitgestellt.

Der thermoelektrische Gegenstand kann zumindest eine Phase mit einer Halb-Heusler-Struktur aufweisen. In manchen Ausführungsbeispielen weist der thermoelektrische Gegenstand zumindest zwei Phasen mit einer Halb-Heusler-Struktur auf, die unterschiedliche Zusammensetzungen aufweisen. Die Phase oder Phasen mit der Halb-Heusler-Struktur können jeweils weniger als 0,2 Atom-% an einem oder beiden der Elemente A und B aufweisen, sodass diese Elemente hauptsächlich in Form von A-reichen und/oder B-reichen Ausscheidungen vorhanden sind. 0,2 Atom-% ist zum Beispiel die Nachweisgrenze von Methoden wie energiedispersiver Röntgenspektroskopie.

Die Zusammensetzung der Phasen mit der Halb-Heusler-Struktur kann durch die Summenformel TiₐZr₁₋ₐNiSnr_{*1*-*b*}Sb*_{b}* gegeben werden, wobei 0 ≤ a ≤ 1 und 0 ≤ *b ≤* 0,1 ist. In manchen Ausführungsbeispielen beträgt 0,2 ≤ *a* ≤ 0,8.

Erfindungsgemäß wird auch ein Verbundmaterial für eine thermoelektrische Umwandlungsvorrichtung angegeben, das eine Matrix mit zumindest einer Phase mit einer Halb-Heusler-Struktur auf αNiβ - Basis aufweist, wobei α zumindest eines der Elemente der Gruppe bestehend aus Ti und Zr und optional Hf ist und β zumindest eines der Elemente der Gruppe bestehend aus Sn und Sb ist, wobei der Anteil an Hf in Ti+Zr+Hf weniger als 5 Atom-% ist, Einschlüsse aus einer A-reichen Phase, wobei A eines oder mehrere der Elemente ausgewählt aus der Gruppe bestehend aus Sc, Y und La ist, und/oder Einschlüsse aus einer B-reichen Phase, wobei B eines oder mehrere der Elemente ausgewählt aus der Gruppe bestehend aus V, Nb und Ta ist, und ein Maximum der thermoelektrischen Gütezahl ZTₘₐₓ von ≥ 0,8, vorzugsweise ≥ 0,9 aufweist. Das Verbundmaterial weist eine Gesamtzusammensetzung bestehend im Wesentlichen aus 6 Atom-% ≤ Ti ≤ 27 Atom-%, 6 Atom-% ≤ Zr ≤ 27 Atom-%, 0 Atom-% ≤ Hf ≤ 1,7 Atom-%, wobei 28 Atom-% ≤ (Ti + Zr + Hf) ≤ 38 Atom-% ist, 28 Atom-% ≤ Sn ≤ 38 Atom-%, 0 Atom-% ≤ Sb ≤ 3 Atom-%, wobei 28 Atom-% ≤ (Sn + Sb) ≤ 38 Atom-% ist, 0 Atom-% ≤ A ≤ 7 Atom-%, 0 Atom-% ≤ B ≤ 7 Atom-%, wobei A eines oder mehrere der Elemente ausgewählt aus der Gruppe bestehend aus Sc, Y und La ist, B eines oder mehrere der Elemente ausgewählt aus der Gruppe bestehend aus V, Nb und Ta ist, und 0,15 Atom-% ≤ A+B ≤ 7 ist, Rest Ni sowie bis zu 5 Atom-% Verunreinigungen auf.

Dieses Verbundmaterial weist somit gute thermoelektrische Eigenschaften trotz der Einschlüsse von zusätzlichen Phasen neben der Halb-Heusler-Verbindung oder Verbindungen auf.

Die Zusammensetzung der Phasen mit der Halb-Heusler-Struktur kann durch die Summenformel Ti*ₐ*Zr_{1-*a*}NiSn1_{-*b*}Sb*_{b}* gegeben werden, wobei 0≤ a ≤1 und 0 ≤ *b* ≤ 0,1 und in einem Ausführungsbeispiel 0,2 ≤ a ≤ 0,8 ist.

In einem Ausführungsbeispiel weist die Matrix weniger als jeweils 0,2 Atom-% an einem oder mehreren der Elemente A und B auf. Die Einschlüsse aus einer A-reichen Phase und die Einschlüsse aus einer B-reichen Phase weisen in manchen Ausführungsbeispielen im Gegensatz zu der Matrix keine Halb-Heusler-Struktur auf. Das Verbundmaterial kann bis zu 10 Vol-% der A-reichen Phase und der B-reichen Phase aufweisen. Das Verbundmaterial weist somit eine Halb-Heusler-Struktur mit keinen oder sehr niedrigen Substitutionen der Elemente A und B und gute thermoelektrische Eigenschaften auf.

Eines oder beide der Elemente Ti und Zr der Halb-Heusler Phase kann teilweise mit Hf ersetzt werden, wobei der Anteil an Hf in der Summe (Ti+Zr+Hf) ≤ 5 Atom-% beträgt, d.h. der Anteil an Hf auf dem α Gitterplatz der Halb-Heusler Phase weniger als 5 Atom% ist.

Die Verunreinigungen können eines oder mehrere Elemente der Gruppe bestehend aus O, C, N, Al, Fe aufweisen. Der maximale Gehalt an den einzelnen Elementen kann O ≤ 4 Atom-%, C ≤ 1 Atom-%, N ≤ 0,5 Atom-%, Al ≤ 2 Atom-% und Fe ≤ 2 Atom-% sein, wobei der maximale Gesamtgehalt an Verunreinigungen bis zu 5 Atom.-% sein kann.

Ein thermoelektrisches Modul mit zumindest einem thermoelektrischen Element aus einem Verbundmaterial nach einem der oben beschriebenen Ausführungsbeispiele wird auch angegeben.

Erfindungsgemäß weist ein Verfahren zum Herstellen eines thermoelektrischen Gegenstands für eine thermoelektrische Umwandlungsvorrichtung Folgendes auf. Ein Ausgangsmaterial, das aus 6 Atom-% ≤ Ti ≤ 27 Atom-%, 6 Atom-% ≤ Zr ≤ 27 Atom-%, 0 Atom-% ≤ Hf ≤ 1,7 Atom-%, wobei 28 Atom-% ≤ (Ti + Zr + Hf) ≤ 38 Atom-% ist, 28 Atom-% ≤ Sn ≤ 38 Atom-%, 0 Atom-% ≤ Sb ≤ 3 Atom-%, wobei 28 Atom-% ≤ (Sn + Sb) ≤ 38 Atom-% ist, 0 Atom-% ≤ A ≤ 7 Atom-%, 0 Atom-% ≤ B ≤ 7 Atom-%, wobei A eines oder mehrere der Elemente ausgewählt aus der Gruppe bestehenden aus Sc, Y und La ist, B eines oder mehrere der Elemente ausgewählt aus der Gruppe bestehend aus V, Nb und Ta ist, und 0,15Atom-% ≤ A+B ≤ 7 Atom-% ist, Rest Ni sowie bis zu 5 Atom-% Verunreinigungen besteht, wird bereitgestellt, erschmolzen und anschließend erstarrt, um mindestens einen Block zu formen. Der Block wird bei einer Temperatur von 900°C bis 1200°C für eine Zeitdauer t, wobei 0,5 h ≤ t ≤ 100 h, wärmebehandelt bzw. homogenisiert, um einen homogenisierten Block herzustellen. Der homogenisierte Block wird zerkleinert und gemahlen, wobei ein Pulver geformt wird. Das Pulver wird kaltgepresst, wobei ein Grünkörper geformt wird. Der Grünkörper wird unter einem Druck vom maximal 1 MPa bei einer Temperatur von 1000°C bis 1500°C für 0,5 h bis 24h gesintert, wobei ein thermoelektrischer Gegenstand hergestellt wird.

Die Verunreinigungen können eines oder mehrere Elemente der Gruppe bestehend aus O, C, N, Al, Fe aufweisen. Der maximale Gehalt an den einzelnen Elementen kann O ≤ 4 Atom-%, C ≤ 1 Atom-%, N ≤ 0,5 Atom-%, Al ≤ 2 Atom-% und Fe ≤ 2 Atom-% sein, wobei der maximale Gesamtgehalt an Verunreinigungen bis zu 5 Atom.-% sein kann.

Im thermoelektrischen Gegenstand können eines oder beide der Elemente Ti und Zr der Halb-Heusler Phase teilweise mit Hf ersetzt werden, wobei der Anteil an Hf auf dem α Gitterplatz der Halb-Heusler-Phase und in der Summe (Ti+Zr+Hf) ≤ 5 Atom-% beträgt.

Das erschmolzene Ausgangsmaterial kann zu einem Block gegossen werden. Der Block bzw. Gussblock kann mittels eines Backenbrechers und/oder mittels einer Scheibenmühle oder Walzenmühle zerkleinert werden. Der Block kann in mehreren Schritten zu einem Pulver verarbeitet werden. Zum Beispiel kann der Block zu einem groben Pulver zerkleinert und das grobe Pulver mit einem weiteren Mahlverfahren zu einem feinen Pulver gemahlen werden, wobei das feine Pulver kaltgepresst wird, um den Grünkörper zu formen. Das weitere Mahlverfahren kann mittels einer Planetenkugelmühle oder einer Jet-Mühle durchgeführt werden.

Das Ausgangsmaterial kann mittels Vakuum-Induktions-Schmelzen (VIM) erschmolzen werden. Vakuum-Induktions-Schmelzen ist insbesondere zum Herstellen von großtechnischen Mengen an Material vorteilhaft.

Der Block kann unter Argon oder in einem Vakuum homogenisiert wird. In einem Ausführungsbeispiel sind die Wärmbehandlungsbedingungen für die Homogenisierung näher definiert, sodass der Block bei einer Temperatur von 1050°C bis 1180°C für eine Zeitdauer t, wobei 16 h ≤ t ≤ 36h beträgt, homogenisiert wird.

Der Anteil an Verunreinigungen kann sich aufgrund des Herstellungsverfahrens erhöhen, sodass der Anteil an Verunreinigungen im fertigen Gegenstand bis zu 5 Atom-% beträgt.

In den oben beschriebenen Ausführungsbeispielen weist das Ausgangsmaterial, das erschmolzen und zu einem Pulver verarbeitet wird, den gewünschte Gehalt an den Elementen Ti, Zr, Hf, A, B, Sn, Sb und Ni auf. In weiteren Ausführungsbeispielen wird die Gesamtzusammensetzung aus zwei oder mehreren Pulvern unterschiedlicher Zusammensetzungen bereitgestellt.

Ein Verfahren zum Herstellen eines thermoelektrischen Gegenstands wird bereitgestellt, wobei zumindest ein Pulver, das die Elemente A und/oder B enthält, mit einem Pulver gemischt wird, das keine dieser Elemente oder weniger als den gewünschten Anteil an diesen Elementen aufweist. Das Verfahren kann Folgendes aufweisen. Ein erstes Pulver, das aus 6 Atom-% ≤ Ti ≤ 27 Atom-%, 6 Atom-% ≤ Zr ≤ 27 Atom-%, 0 Atom-% ≤ Hf ≤ 1,7 Atom-%, wobei 28 Atom-% ≤ (Ti + Zr + Hf) ≤ 38 Atom-% ist, 28 Atom-% ≤ Sn ≤ 38 Atom-%, 0 Atom-% ≤ Sb ≤ 3 Atom-%, wobei 28 Atom-% ≤ (Sn + Sb) ≤ 38 Atom-% ist, Rest Ni sowie bis zu 5 Atom% Verunreinigungen besteht, wobei der Anteil an Elementen der Gruppen A und B weniger als 0,2 Atom-% beträgt, wird bereitgestellt. Zumindest ein zweites Pulver, das 0 Atom-% ≤ A ≤ 7 Atom-% und/oder 0 Atom-% ≤ B ≤ 7 Atom-% aufweist, wobei A eines oder mehrere der Elemente ausgewählt aus der Gruppe bestehenden aus Sc, Y und La ist und B eines oder mehrere der Elemente ausgewählt aus der Gruppe bestehend aus V, Nb und Ta ist, und 0,5 Atom-% ≤ A+B ≤ 7 Atom-% ist, wird bereitgestellt. Das erste Pulver und das zweite Pulver werden miteinander gemischt, wodurch ein Ausgangspulver erzeugt wird.

Dieses Ausgangspulver wird kaltgepresst, um einen Grünkörper zu formen und der Grünkörper unter einem Druck vom maximal 1 MPa bei einer Temperatur von 1000°C bis 1500°C für 0,5 h bis 24h gesintert, wobei ein thermoelektrischer Gegenstand hergestellt wird.

Das zweite Pulver kann neben die Elemente A und/oder B ferner 6 Atom-% ≤ Ti ≤ 27 Atom-%, 6 Atom-% ≤ Zr ≤ 27 Atom-%, 0 Atom-% ≤ Hf ≤ 1,7 Atom-%, wobei 28 Atom-% ≤ (Ti + Zr + Hf) ≤ 38 Atom-% ist, 28 Atom-% ≤ Sn ≤ 38 Atom-%, 0 Atom-% ≤ Sb ≤ 3 Atom-%, wobei 28 Atom-% ≤ (Sn + Sb) ≤ 38 Atom-%, Rest Ni sowie bis zu 5 Atom% Verunreinigungen aufweisen. Das zweite Pulver kann somit eine oder mehrere Phasen mit einer Halb-Heusler-Struktur aufweisen.

Für beide Herstellungsmethoden kann der Grünkörper unter Schutzgas oder einem Vakuum gesintert werden. Der gesinterte thermoelektrische Gegenstand kann auch weiter bearbeitet werden, um zumindest eine Arbeitskomponente herzustellen, die geeignet zur Anwendung in einem thermoelektrischen Modul ist. Zum Beispiel kann der gesinterte Gegenstand mittels Säge- und/oder Schleifverfahren zu mehreren Arbeitskomponenten verarbeitet werden.

Der gesinterte thermoelektrische Gegenstand, der mit beiden Verfahren hergestellt wird, kann eine Matrix aus zumindest einer Phase mit einer Halb-Heusler-Struktur mit weniger als 0,2 Atom-% der Elemente A und B sowie Einschlüsse bzw. Ausscheidungen aus A-reichen und/oder B-reichen Phasen aufweisen. Der gesinterte thermoelektrische Gegenstand kann bis zu 10 Vol-% an diesen A-reichen und B-reichen Phasen aufweisen und trotzdem thermoelektrische Eigenschaften von einem Maximum der thermoelektrischen Gütezahl ZTₘₐₓ von ≥ 0,8 vorzugsweise ≥ 0,9 aufweisen, wobei 400°C ≤ Tₘₐₓ ≤ 700°C sein kann, und/oder einem Seebeck-Koeffizienten S, wobei - 350 (µV/K) ≤ S ≤- 80 (µV/K) ist, und/oder ein Maximum des Power-Faktors PFₘₐₓ von >3,5 (mW m⁻¹ K⁻²) aufweisen.

Die Erfindung wird nun anhand der Zeichnungen und Beispiele näher erläutert.
- Figur 1: zeigt ein Diagramm der Zusammensetzung des α-Gitterplatzes in der Verbindung αNiSn (α= Ti, Zr, Hf), wobei der schattierte Bereich den untersuchten Bereich für α darstellt.
- Figur 2: zeigt eine rasterelektronenmikroskopische Aufnahme der Mikrostruktur von Beispiel 1.1.
- Figur 3: zeigt eine rasterelektronenmikroskopische Aufnahme der Mikrostruktur des Materials aus Beispiel 2.4.
- Figur 4: zeigt Graphen der thermoelektrischen Eigenschaften der Materialien aus Beispiel 3.
- Figur 5: zeigt eine rasterelektronenmikroskopische Aufnahme der Mikrostruktur des Materials aus Beispiel 4.1
- Figur 6: zeigt eine rasterelektronenmikroskopische Aufnahme der Mikrostruktur des Materials aus Beispiel 4.2
- Figur 7: zeigt Graphen der thermoelektrischen Eigenschaften der Materialien aus Beispiel 5.
- Figur 8: zeigt Graphen der thermoelektrischen Eigenschaften der Materialien aus Beispiel 6.

Ein thermoelektrischer Gegenstand mit einer Gesamtzusammensetzung bestehend im Wesentlichen aus 6 Atom-% ≤ Ti ≤ 27 Atom-%, 6 Atom-% ≤ Zr ≤ 27 Atom-%, wobei 28 Atom-% ≤ (Ti + Zr) ≤ 38 Atom-% ist, 0 Atom-% ≤ Hf ≤ 1,7 Atom-%, wobei eines oder beide der Elemente Ti und Zr der Halb-Heusler-Phase teilweise mit Hf ersetzt werden kann so dass wobei 28 Atom-% ≤ (Ti + Zr + Hf) ≤ 38 Atom-% ist, wobei der Anteil an Hf in der Summe (Ti+Zr+Hf) ≤ 5 Atom-% beträgt, 28 Atom-% ≤ Sn ≤ 38 Atom-%, 0 Atom-% ≤ Sb ≤ 3 Atom-%, wobei 28 Atom-% ≤ (Sn + Sb) ≤ 38 Atom-% ist, 0 Atom-% ≤ A ≤ 7 Atom-%, 0 Atom-% ≤ B ≤ 7 Atom-%, wobei A eines oder mehrere der Elemente ausgewählt aus der Gruppe bestehenden aus Sc, Y und La ist, B eines oder mehrere der Elemente ausgewählt aus der Gruppe bestehend aus V, Nb und Ta ist, und 0,15 Atom-% ≤ A+B ≤ 7 Atom-% ist, Rest Ni sowie bis zu 5 Atom-% Verunreinigungen, wird bereitgestellt. Der thermoelektrische Gegenstand hat eine gesinterte mehrphasige Verbundstruktur mit einer Matrix aus zumindest einer Phase mit einer Halb-Heusler-Struktur mit weniger als 0,2 Atom-% der Elemente A und B sowie Einschlüsse bzw. Ausscheidungen aus A-reichen und/oder B-reichen Phasen, die in der Matrix eingebettet sind.

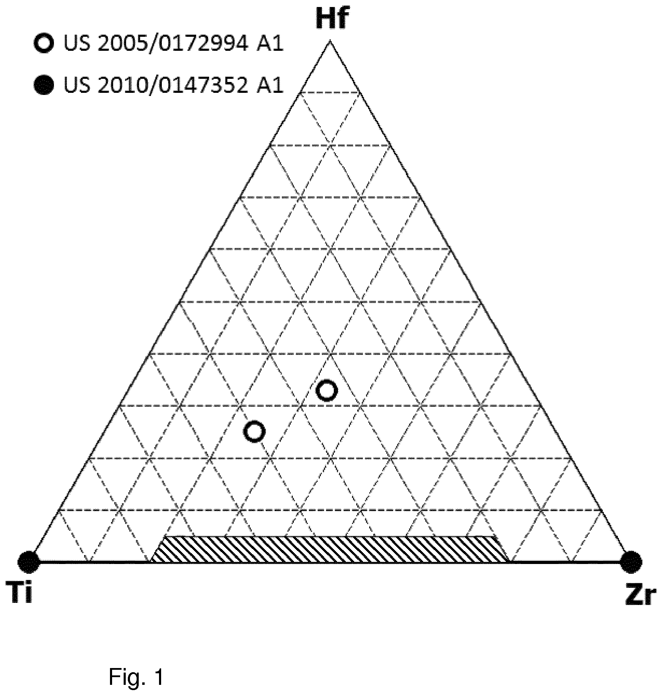

In den vorliegenden Beispielen weist die Gesamtzusammensetzung die beiden Elemente Ti*_{c}*Zr_{1-*c*} im Verhältnis 0,2 ≤ *c* ≤ 0,8 auf, mit nur einem geringen Anteil an Hafnium. Die bezüglich der A- und B-Substitution in dieser Arbeit untersuchten Zusammensetzungsbereiche des α-Gitterplatzes sind zur Verdeutlichung durch den schraffierten Bereich in Figur 1 dargestellt. Die im Stand der Technik in den Druckschriften US2005/0172994 A1 und US2010/0147352 A1 bezüglich der A- und B-Substitution untersuchten Zusammensetzungen sind mit Punkten dargestellt.

Es wurde eine Versuchsserie durchgeführt, mit der der Einfluss der Substitution mit A- und B-Atomen im System A*ₓ*B*_{y}*Ti*_{c}*Zr_{1-*c*})_{1-*x*-*y*}NiSn untersucht wird. Dabei wurden *x* und *y* zwischen 0,005 ≤ *x,y ≤* 0,13 variiert. Der Zielbereich für die Zusammensetzung auf dem α-Gitterplatz wurde mit *c* zwischen 0,2 ≤ *c* ≤ 0,8 festgelegt. Die Elemente Ti und Zr wurden dabei teilweise mit geringen Mengen an Hf ersetzt, wobei der Anteil an Hf in Ti+Zr+Hf kleiner als 5 Atom-% betrug.

In den Versuchen wurde festgestellt, dass überraschenderweise keine reinen Halb-Heusler-Verbindungen erhalten werden. Die Atome aus den Gruppen A und B konnten nicht in der Halb-Heusler-Phase gelöst nachgewiesen werden, wobei die Nachweisgrenze bei der verwendeten Analysemethode der energiedispersiven Röntgenspektroskopie bei ca. 0,2% liegt. Stattdessen bildeten sich selbst bei geringer Menge an Substitutionsatomen (*x*,*y*=0,005) A- und B-reiche Fremdphasen.

Ebenfalls überraschend wurden an diesen Halb-Heusler-Verbindungen mit eingebauten A- und B-reichen Fremdphasen gute thermoelektrische Eigenschaften mit hohen ZT-Werten gemessen, so dass zum Erhalt guter thermoelektrischer Materialien das Auftreten von Fremdphasen nicht zu vermeiden ist.

Die Löslichkeit der A- und B-Atome scheint in den hierin beschriebenen Halb-Heusler-Verbindungen Ti*_{c}*Zr_{1-*c*}NiSn mit 0,2 ≤ *c* ≤ 0,8 stark herabgesetzt zu sein, wodurch es zu den beobachteten Fremdphasen kommt. Diese fehlende Löslichkeit in der Halb-Heusler-Phase ist überraschend. Ebenfalls überraschend ist, dass diese Fremdphasen einen vorteilhaften Einfluss auf die thermoelektrischen Eigenschaften besitzen.

### Beispiel 1

Es wurden Materialien mit der in Tabelle 1 gezeigten Zusammensetzung hergestellt. Dazu wurden die Materialien in der gegebenen Zusammensetzung zunächst mittels Vakuum-Induktionsschmelzen erschmolzen. Aufgrund des Gehaltes von 2,7 Masse-% Hf als Begleitelement im eingesetzten Zr ist in den so erschmolzenen Materialien 0,4 Atom-% des Zr und Ti mit Hf ersetzt. Der Gussblock wurde weiterverarbeitet, indem er zunächst bei 1000 °C für 24 Stunden unter Argon als Schutzgas homogenisiert und anschließend zu einem feinen Pulver mit Median der Korngröße kleiner als 10 µm gemahlen wurde. Das Pulver wurde in einer Werkzeugpresse bei einem Druck von 2 t/cm² zu Grünkörpern gepresst und schließlich bei 1100 °C bis 1300 °C für 4 Stunden unter Vakuum zu einem dichten Körper gesintert.

**Tabelle 1: Zusammensetzung der Materialien nach Beispiel 1 und deren Seebeck-Koeffizient bei Raumtemperatur.**

| | Zusammensetzung in Atom-% | *S* (µV/K) @ RT |
|---|---|---|
| Beispiel 1.1 | 4,2% La - 4,2% Ta - 16,7% Ti - 8,3% Zr - 33,3% Sn - Rest Ni | -38 |
| Beispiel 1.2 | 4,2% Y - 4,2% Ta - 16,7% Ti - 8,3% Zr - 33,3% Sn - Rest Ni | -56 |
| Beispiel 1.3 | 4,2% La - 4,2% Nb - 16,7% Ti - 8,3% Zr - 33,3% Sn - Rest Ni | -22 |
| Beispiel 1.4 | 4,2% Y - 4,2% Nb - 16,7% Ti - 8,3% Zr - 33,3% Sn - Rest Ni | -41 |

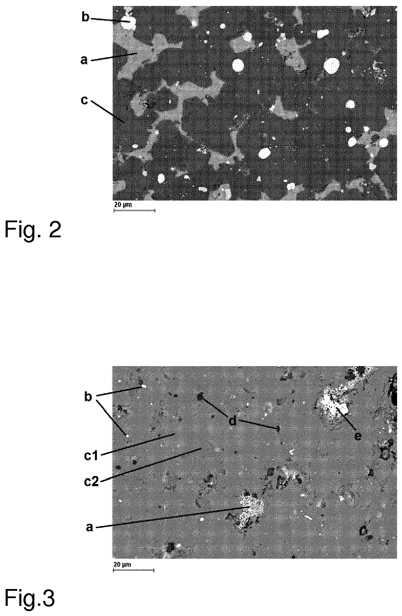

Die Mikrostruktur der so hergestellten Materialien wurde mittels Rasterelektronenmikroskopie (REM) untersucht. Figur 2 zeigt eine rasterelektronenmikroskopische Aufnahme der Mikrostruktur des Materials aus Beispiel 1.1. In allen Beispielen liegt in den Materialien eine Hauptphase in der Zusammensetzung einer Halb-Heusler-Phase vor (Phase c in der Figur 2) der Zusammensetzung 16,4% Ti - 16,9% Zr - 33,3% Sn - Rest Ni, bzw. ∼Ti_{0,5}Zr_{0,5}NiSn). Neben der Hauptphase treten zwei unterschiedliche Nebenphasen auf, die eine hohe Konzentration an jeweils einem der zugesetzten Elemente der Gruppen A und B aufweisen (Phasen a und b in der Figur 2). In der Hauptphase sind die zugesetzten Elemente der Gruppen A und B dagegen mittels energiedispersiver Röntgenspektroskopie (EDX) nicht nachweisbar, wobei die Nachweisgrenze bei ca. 0,2 Atom-% liegt. Beispiel 1 zeigt somit deutlich, dass die erwartete Löslichkeit der Elementgruppen A und B im System αNiSn nicht für die gemischte Besetzung des α-Gitterplatzes mit Ti und Zr erreicht wird.

Aus den Materialien wurden Stäbchen der Abmessung 3 mm × 3 mm × 13 mm gesägt. An diesen Proben wurde der Seebeck-Koeffizient bei Raumtemperatur bestimmt, welcher ebenfalls in Tabelle 1 gelistet ist. Im Maximum beträgt dieser -56 µV/K für Beispiel 1.2. Damit besitzen die Materialien aus Beispiel 1 einen zu geringen Seebeck-Koeffizienten, um für die praktische thermoelektrische Energiewandlung nützlich zu sein. Allerdings ist der Anteil der A- und B-reichen Nebenphasen in Beispiel 1 sehr hoch. Mit der Versuchsreihe im folgenden Beispiel 2 sollte daher der Einfluss eines geringeren Anteils an diesen Fremdphasen auf die thermoelektrischen Eigenschaften untersucht werden.

### Beispiel 2

Zunächst wurde als vergleichendes Beispiel ein Pulver aus einem Material ohne Elemente der Gruppen A und B wie in Beispiel 1 hergestellt. Die Zusammensetzung entspricht der einer Halb-Heusler-Phase und ist in Tabelle 2 wiedergegeben. Aufgrund des Gehaltes von 2,7 Masse-% Hf als Begleitelement im eingesetzten Zr ist in Summe 0,7 Atom-% des Zr und Ti mit Hf ersetzt. Durch Mischen der Pulver aus Beispiel 1 mit dem Pulver aus Beispiel 2.1 in verschiedenen Verhältnissen und durch anschließendes Pressen und Sintern der Pulvermischungen wie in Beispiel 1 wurden weitere Materialien hergestellt, deren Zusammensetzungen ebenfalls in Tabelle 2 wiedergegeben sind. Die Materialien aus Beispiel 2 enthalten geringere Anteile an Elementen der Gruppen A und B als in Beispiel 1.

**Tabelle 2: Zusammensetzung der Materialien nach Beispiel 2.**

| | Zusammensetzung in Atom-% |
|---|---|
| Vgl. Beispiel 2.1 | 16,7% Ti - 16,7% Zr - 33,3% Sn - Rest Ni |
| Beispiel 2.2 | 0,17% La - 0,17% Ta - 16,7% Ti - 16,3% Zr - 33,3% Sn - Rest Ni |
| Beispiel 2.3 | 0,5% La - 0,5% Ta - 16,7% Ti - 15,7% Zr - 33,3% Sn - Rest Ni |
| Beispiel 2.4 | 0,8% La - 0,8% Ta - 16,7% Ti - 15,0% Zr - 33,3% Sn - Rest Ni |
| Beispiel 2.5 | 1,7% La - 1,7% Ta - 16,7% Ti - 13,3% Zr - 33,3% Sn - Rest Ni |
| Beispiel 2.6 | 0,5% Y - 0,5% Ta - 16,7% Ti - 15,7% Zr - 33,3% Sn - Rest Ni |
| Beispiel 2.7 | 0,8% Y - 0,8% Ta - 16,7% Ti - 15,0% Zr - 33,3% Sn - Rest Ni |
| Beispiel 2.8 | 0,5% La - 0,5% Nb - 16,7% Ti - 15,7% Zr - 33,3% Sn - Rest Ni |
| Beispiel 2.9 | 0,8% La - 0,8% Nb - 16,7% Ti - 15,0% Zr - 33,3% Sn - Rest Ni |
| Beispiel 2.10 | 0,5% Y - 0,5% Nb - 16,7% Ti - 15,7% Zr - 33,3% Sn - Rest Ni |
| Beispiel 2.11 | 0,8% Y - 0,8% Nb - 16,7% Ti - 15,0% Zr - 33,3% Sn - Rest Ni |

Die Mikrostruktur der Materialien wurde mittels REM untersucht. Beispielhaft ist in der Figur 3 die Mikrostruktur des Materials aus Beispiel 2.4 gezeigt. In allen Fällen treten Hauptphasen in Form von Halb-Heusler-Phasen (Phasen c1 und c2 in der Figur 3) sowie A- und B-reiche Nebenphasen auf (Phasen a und b in der Figur 3). In einigen Fällen können in der Mikrostruktur auch Poren durch eine nicht vollständige Sinterung (d) oder Einschlüsse einer Ni-Sn-Phase (e) beobachtet werden.

Die EDX-Analyse der Halb-Heusler-Phasen in der Figur 3 ergab zwei unterschiedliche Zusammensetzungen 12,9% Ti - 21,4% Zr - 34,0% Sn - Rest Ni (c1) und 20,3% Ti - 13,1% Zr - 34,6% Sn - Rest Ni (c2). Auch in den Beispielen 2.2 bis 2.11 wurde keine Löslichkeit der Elemente aus den Gruppen A und B oberhalb der Nachweisgrenze von 0,2 % in der Halb-Heusler-Phase festgestellt.

Aus den Materialien wurden Stäbchen der Abmessung 3 mm × 3 mm × 13 mm gesägt. An diesen Proben wurden der Seebeck-Koeffizient und die elektrische Leitfähigkeit gemessen. Die Ergebnisse sowie der daraus berechnete Power-Faktor sind in Tabelle 3 gelistet. Wie aus der Tabelle ersichtlich, besitzen die Materialien aus Beispiel 2 einen deutlich höheren Seebeck-Koeffizienten als die Materialien aus Beispiel 1. Darüber hinaus ist der Power-Faktor in allen Beispielen 2.2 bis 2.11, welche einen Anteil an A- und B-reichen Fremdphasen besitzen, deutlich höher als im Vergleichsbeispiel 2.1, welches aus einer Halb-Heusler-Phase ohne A- und B-reichen Fremdphasen besteht. In Beispiel 2 wird daher demonstriert, dass wider Erwarten das Vorhandensein A- und B-reicher Fremdphasen die thermoelektrischen Eigenschaften nicht verschlechtert, sondern verbessert.

**Tabelle 3: Thermoelektrische Eigenschaften der Materialien aus Beispiel 2 bei Raumtemperatur und 400°C.**

| | RT | | | 400 °C | | |
|---|---|---|---|---|---|---|
| | *S* (µV/K) | *σ* (S/cm) | *PF* (mWm⁻¹K⁻²) | *S* (µV/K) | *σ* (S/cm) | *PF* (mWm⁻¹K⁻²) |
| Vgl. Beispiel 2.1 | -248 | 198 | 1,2 | -241 | 478 | 2,8 |
| Beispiel 2.2 | -199 | 482 | 1,9 | -226 | 643 | 3,3 |
| Beispiel 2.3 | -144 | 1061 | 2,2 | -203 | 890 | 3,7 |
| Beispiel 2.4 | -123 | 1474 | 2,2 | -185 | 1140 | 3,9 |
| Beispiel 2.5 | -85 | 2637 | 1,9 | -141 | 1866 | 3,7 |
| Beispiel 2.6 | -143 | 1142 | 2,3 | -200 | 967 | 3,9 |
| Beispiel 2.7 | -137 | 1211 | 2,3 | -196 | 1020 | 3,9 |
| Beispiel 2.8 | -131 | 1196 | 2,1 | -185 | 1035 | 3,6 |
| Beispiel 2.9 | -97 | 1954 | 1,8 | -154 | 1466 | 3,5 |
| Beispiel 2.10 | -138 | 1111 | 2,1 | -192 | 976 | 3,6 |
| Beispiel 2.11 | -112 | 1544 | 1,9 | -169 | 1203 | 3,4 |

### Beispiel 3

In Beispiel 3 wird der Effekt der A- und B-reichen Fremdphasen für Halb-Heusler-Verbindungen mit einem weiteren Zusammensetzungsbereich des α-Gitterplatzes untersucht. Dazu wurden zunächst A- und B-freie Halb-Heusler-Verbindungen mit Zusammensetzung 10,0% Ti - 23,3% Zr - 33,3% Sn - Rest Ni (Ti_{0,3}Zr_{0,7}NiSn), 13,3% Ti - 20,0% Zr - 33,3% Sn - Rest Ni (Ti_{0,4}Zr_{0,6}NiSn) und 23,3% Ti - 10,0% Zr - 33,3% Sn - Rest Ni (Ti_{0,7}Zr_{0,3}NiSn) wie in Beispiel 1 erschmolzen. Aufgrund des Gehaltes von 2,7 Masse-% Hf als Begleitelement im eingesetzten Zr sind in den Verbindungen in Summe 1 %, 0,8 % bzw. 0,4 % des Zr und Ti mit Hf ersetzt. Wie in Beispiel 2 wurden die Verbindungen zu Pulver verarbeitet und anschließend in verschiedenen Verhältnissen mit den Pulvern der Materialien aus Beispiel 1 gemischt. Durch Sintern wurden daraus dichte Probekörper mit den in Tabelle 4 gelisteten Zusammensetzungen hergestellt.

**Tabelle 4: Zusammensetzung der Materialien nach Beispiel 3.**

| | Zusammensetzung in Atom-% |
|---|---|
| Beispiel 3.1 | 0,3% La - 0,3% Ta - 10,5% Ti - 22,1% Zr - 33,3% Sn - Rest Ni |
| Beispiel 3.2 | 0,8% La - 0,8% Ta - 11,3% Ti - 20,3% Zr - 33,3% Sn - Rest Ni |
| Beispiel 3.3 | 0,3% La - 0,3% Ta - 13,6% Ti - 19,1% Zr - 33,3% Sn - Rest Ni |
| Beispiel 3.4 | 0,8% La - 0,8% Ta - 14,0% Ti - 17,7% Zr - 33,3% Sn - Rest Ni |
| Beispiel 3.5 | 0,8% Y - 0,8% Ta - 11,3% Ti - 20,3% Zr - 33,3% Sn - Rest Ni |
| Beispiel 3.6 | 0,8% Y - 0,8% Ta - 22,0% Ti - 10,0% Zr - 33,3% Sn - Rest Ni |

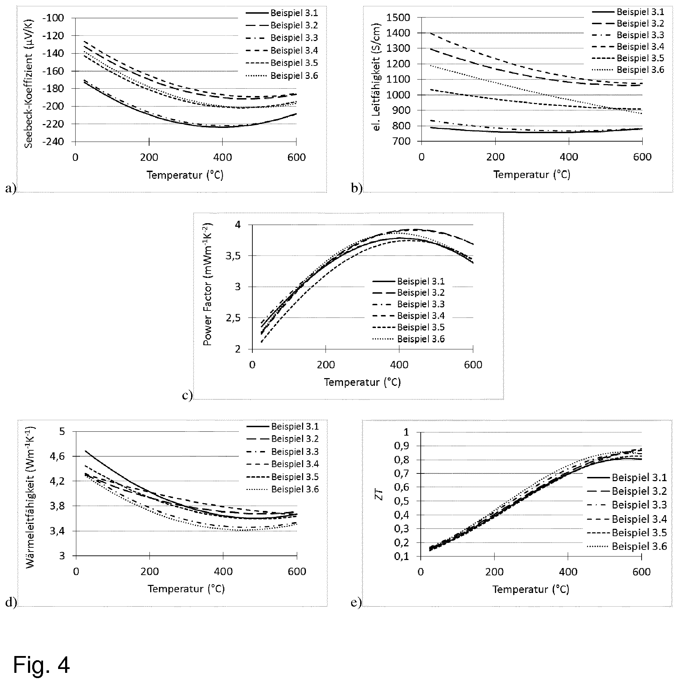

Aus den Materialien wurden wieder Stäbchen der Abmessung 3 mm × 3 mm × 13 mm zur Messung des Seebeck-Koeffizienten und der elektrische Leitfähigkeit gesägt. Zusätzlich wurden Proben der Abmessung 10 mm × 10 mm × 1 mm zur Messung der Wärmeleitfähigkeit mittels der Laser-Flash-Methode hergestellt. Die für die Materialien damit gemessenen temperaturabhängigen thermoelektrischen Eigenschaften sind in Figur 4 gezeigt.

Figur 4a zeigt einen Graph der Seebeck-Koeffizienten in Abhängigkeit der Temperatur. Figur 4b zeigt einen Graph der elektrischen Leitfähigkeit in Abhängigkeit der Temperatur. Figur 4c zeigt einen Graph des Power-Faktors in Abhängigkeit der Temperatur. Figur 4d zeigt einen Graph der Wärmeleitfähigkeit in Abhängigkeit der Temperatur. Figur 4e zeigt einen Graph der Gütezahl ZT in Abhängigkeit der Temperatur.

Alle Materialien aus Beispiel 3 zeigen einen hohen Seebeck-Koeffizienten. Zusammen mit der gemessenen elektrischen Leitfähigkeit ergeben sich ebenfalls hohe Power-Faktoren vergleichbar mit den Materialien aus Beispiel 2. Das Beispiel 3 zeigt somit, dass die A- und B-reichen Fremdphasen auch in dem erweiterten Zusammensetzungsbereich des α-Gitterplatzes einen vorteilhaften Effekt auf die thermoelektrischen Eigenschaften besitzen.

Dies wird auch durch die Messung der Wärmeleitfähigkeit bestätigt. Wie in Figur 4e) gezeigt, ergibt die Kombination der gemessenen Eigenschaften in allen Fällen einen hohen *ZT-*Wert, dessen Maximum im Temperaturbereich zwischen 500 °C und 600 °C auftritt und zwischen 0,8 ≤ *ZT*ₘₐₓ ≤ 0,9 liegt.

### Beispiel 4

Die Materialien der vorherigen Beispiele enthielten jeweils Elemente aus den beiden Gruppen A und B zusammen. Dabei wurde keine Löslichkeit dieser Elemente in der Halb-Heusler Phase beobachtet. In Beispiel 4 wird demonstriert, dass auch bei Zugabe nur eines Elementes aus einer der Gruppen A oder B keine Löslichkeit dieses Elementes in der Halb-Heusler Phase vorliegt. Dazu wurden die in Tabelle 5 gelisteten Zusammensetzungen mittels Vakuum-Induktionsschmelzen erschmolzen und wie in Beispiel 1 beschrieben verarbeitet.

**Tabelle 5: Zusammensetzung der Materialien nach Beispiel 4.**

| | Zusammensetzung in Atom-% |
|---|---|
| Beispiel 4.1 | 0,8% La - 16,7% Ti - 15,8% Zr - 33,3% Sn - Rest Ni |
| Beispiel 4.2 | 0,8% Ta - 16,7% Ti - 15,8% Zr - 33,3% Sn - Rest Ni |

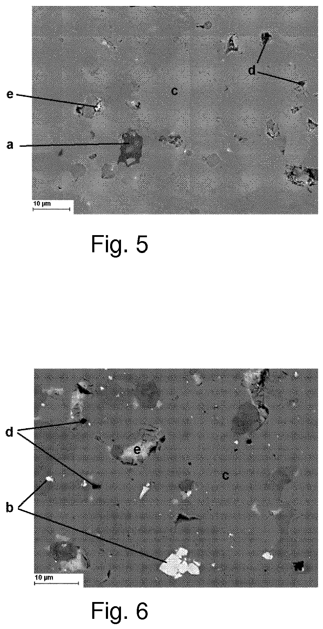

Die so hergestellten Materialien wurden mittels REM analysiert. Die Mikrostrukturen der Materialien aus Beispiel 4 sind in Fig. 5 und Fig. 6 gezeigt. Den Hauptbestandteil des Gefüges bildet in beiden Fällen eine Halb-Heusler-Phase (Phase c in Figur 5 und 6) der Zusammensetzung 16% Ti - 18% Zr - 34% Sn - Rest Ni. In dieser Phase sind die Elemente La oder Ta mittels EDX nicht nachweisbar. Im Gefüge treten dagegen La-reiche Nebenphasen (Phase a in Figur 5) oder Ta-reiche Nebenphasen auf (Phase b in Figur 6) auf. Zusätzlich können Poren (d) und Einschlüsse Sn-reicher Phasen (e) beobachtet werden. Die Ergebnisse der REM Untersuchung demonstrieren daher, dass auch bei Vorhandensein nur eines Elementes aus den Gruppen A und B diese nicht in der Halb-Heusler Phase gelöst werden.

### Beispiel 5

In Beispiel 5 werden die thermoelektrischen Eigenschaften von Materialien mit Ta-reichen Nebenphasen mit den thermoelektrischen Eigenschaften herkömmlicher Halb-Heusler Verbindungen verglichen, bei denen eine Dotierung durch Antimon auf dem Zinn-Gitterplatz realisiert wurde. Dazu wurden die in Tabelle 6 gelisteten Zusammensetzungen mittels Vakuum-Induktionsschmelzen erschmolzen und wie in Beispiel 1 beschrieben verarbeitet. Zusätzlich zu der Verarbeitung wie in Beispiel 1 wurden die Materialien vor der Charakterisierung für 48 Stunden bei 930 °C unter Schutzgas (Argon) geglüht.

**Tabelle 6: Zusammensetzung der Materialien nach Beispiel 5.**

| | Zusammensetzung in Atom-% |
|---|---|
| Beispiel 5.1 | 0,3% Ta - 16,7% Ti - 16,3% Zr - 33,3% Sn - Rest Ni |
| Beispiel 5.2 | 0,8% Ta - 16,7% Ti - 15,8% Zr - 33,3% Sn - Rest Ni |
| Vgl. Beispiel 5.3 | 16,7% Ti - 16,7% Zr - 33,0% Sn - 0,3% Sb - Rest Ni |
| Vgl. Beispiel 5.4 | 16,7% Ti - 16,7% Zr - 32,7% Sn - 0,7% Sb - Rest Ni |

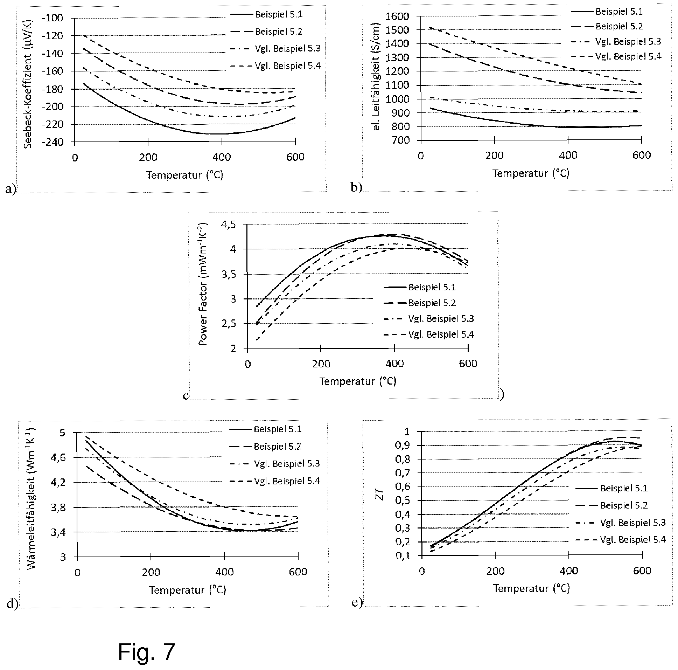

Aus den Materialien wurden Stäbchen der Abmessung 2,5 mm × 2,5 mm × 13 mm zur Messung des Seebeck-Koeffizienten und der elektrische Leitfähigkeit gesägt, sowie Proben der Abmessung 10 mm × 10 mm × 1 mm zur Messung der Wärmeleitfähigkeit mittels der Laser-Flash-Methode. Die für die Materialien damit gemessenen temperaturabhängigen thermoelektrischen Eigenschaften sind in Figur 7 gezeigt.

Figur 7a zeigt einen Graph der Seebeck-Koeffizienten in Abhängigkeit der Temperatur. Figur 7b zeigt einen Graph der elektrischen Leitfähigkeit in Abhängigkeit der Temperatur. Figur 7c zeigt einen Graph des Power-Faktors in Abhängigkeit der Temperatur. Figur 7d zeigt einen Graph der Wärmeleitfähigkeit in Abhängigkeit der Temperatur. Figur 7e zeigt einen Graph der Gütezahl ZT in Abhängigkeit der Temperatur.

Ein Vergleich der Daten zeigt, dass die Materialien aus den Beispielen 5.1 und 5.2 jeweils ähnliche Bereiche für den Seebeck-Koeffizienten und die elektrische Leitfähigkeit abdecken wie die Materialien der vergleichenden Beispiele 5.3 und 5.4. Der Power-Faktor und der ZT-Wert liegen jedoch deutlich höher bei den Materialien aus den Beispielen 5.1 und 5.2. Diese Materialien, die der vorliegenden Erfindung entsprechen und Ta-reiche Nebenphasen enthalten, erzielen maximale ZT-Werte zwischen 0,9 ≤ *ZT*ₘₐₓ ≤ 1,0 im Temperaturbereich von 500 °C bis 600 °C. Die Materialien aus herkömmlich dotierten Halb-Heusler Verbindungen ohne Ta-reiche Fremdphasen erreichen dagegen im gleichen Temperaturbereich nur maximale ZT-Werte kleiner als 0,9.

### Beispiel 6

In Beispiel 6 werden die thermoelektrischen Eigenschaften von Materialien untersucht, die A- und/oder B-reiche Nebenphasen in Kombination mit einer durch Antimon dotierten Halb-Heusler Verbindung besitzen. Dazu wurden die in Tabelle 7 gelisteten Zusammensetzungen erschmolzen, wie in Beispiel 1 verarbeitet und anschließend für 48 Stunden bei 930 °C unter Schutzgas (Argon) geglüht.

**Tabelle 7: Zusammensetzung der Materialien nach Beispiel 6.**

| | Zusammensetzung in Atom-% |
|---|---|
| Beispiel 6.1 | 0,4% Ta - 16,7% Ti - 16,3% Zr - 33,2% Sn - 0,2% Sb - Rest Ni |
| Beispiel 6.2 | 0,4% Ta - 16,7% Ti - 16,3% Zr - 33,0% Sn - 0,3% Sb - Rest Ni |
| Beispiel 6.3 | 0,4% La - 0,4% Ta - 16,7% Ti - 15,8% Zr - 33,0% Sn - 0,3% Sb - Rest Ni |
| Beispiel 6.4 | 0,6% Ta - 16,7% Ti - 15,8% Zr - 1,5% Hf - 33,2% Sn - 0,2% Sb - Rest Ni |

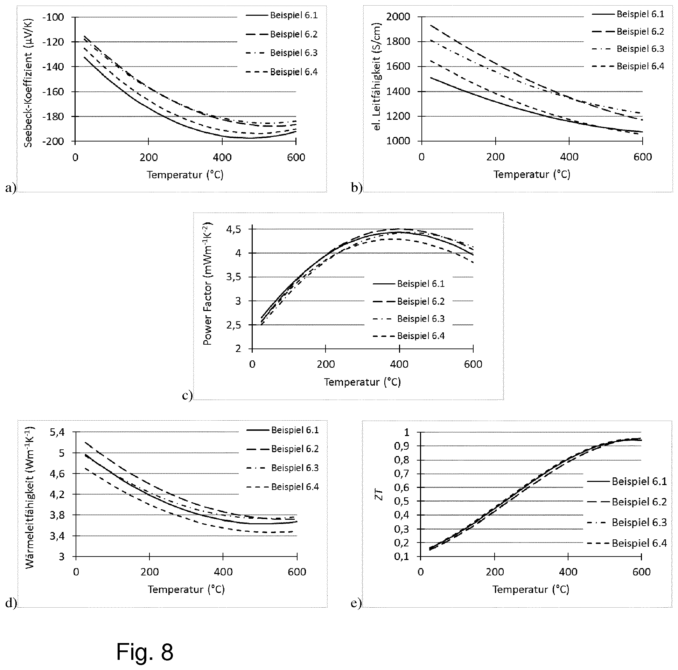

Die aus den Materialien zur thermoelektrischen Charakterisierung präparierten Messproben wurden wie in Beispiel 5 hergestellt. Die gemessenen thermoelektrischen Eigenschaften sind in Figur 8 gezeigt.

Figur 8a zeigt einen Graph der Seebeck-Koeffizienten in Abhängigkeit der Temperatur. Figur 8b zeigt einen Graph der elektrischen Leitfähigkeit in Abhängigkeit der Temperatur. Figur 8c zeigt einen Graph des Power-Faktors in Abhängigkeit der Temperatur. Figur 8d zeigt einen Graph der Wärmeleitfähigkeit in Abhängigkeit der Temperatur. Figur 8e zeigt einen Graph der Gütezahl ZT in Abhängigkeit der Temperatur.

Die Materialien aus Beispiel 6 erzielen alle sehr gute thermoelektrische Eigenschaften, mit hohen Power-Faktoren und einem Maximum des ZT-Wertes im Temperaturbereich zwischen 500 °C und 600 °C von 0,9 ≤ *ZT*ₘₐₓ ≤ 1,0. Insbesondere werden höhere Power-Faktoren und ZT-Werte erreicht als in den vergleichenden Beispielen 5.3 und 5.4, welche mit Antimon dotierte Halb-Heusler Verbindungen ohne A- und/oder B-reiche Nebenphasen darstellen.

Mit der vorliegenden Erfindung können somit leistungsfähigere, Hf-arme thermoelektrische Materialien auf Basis der Halb-Heusler-Verbindungen αNiSn hergestellt werden. Diese Materialien weisen eine mehrphasige Verbundstruktur auf, bei der Einschlüsse aus A-reichen und/oder B-Phasen in einer Matrix mit einer oder mehreren Phasen mit einer Halb-Heusler-Struktur eingebettet sind, wobei die Phasen mit der Halb-Heusler-Struktur zumindest 6 Atom-% Ti und 6 Atom-% Zr aufweisen.

## Patentansprüche

1. Thermoelektrischer Gegenstand für eine thermoelektrische Umwandlungsvorrichtung mit einer Gesamtzusammensetzung bestehend aus
6 Atom-% ≤ Ti ≤ 27 Atom-%,
6 Atom-% ≤ Zr ≤ 27 Atom-%,
0 Atom-% ≤ Hf ≤ 1,7 Atom-%,
wobei 28 Atom-% ≤ (Ti + Zr + Hf) ≤ 38 Atom-% ist,
28 Atom-% ≤ Sn ≤ 38 Atom-%,
0 Atom-% ≤ Sb ≤ 3 Atom-%,
wobei 28 Atom-% ≤ (Sn + Sb) ≤ 38 Atom-%,
0 Atom-% ≤ A ≤ 7 Atom-%,
0 Atom-% ≤ B ≤ 7 Atom-%, wobei A eines oder mehrere der Elemente ausgewählt aus der Gruppe bestehend aus Sc, Y und La ist, B eines oder mehrere der Elemente ausgewählt aus der Gruppe bestehend aus V, Nb und Ta ist, und 0,15 Atom-% ≤ A+B ≤ 7 Atom-% ist,
Rest Ni sowie bis zu 5 Atom-% Verunreinigungen.

2. Thermoelektrischer Gegenstand nach Anspruch 1, wobei der thermoelektrische Gegenstand zumindest eine Phase mit einer Halb-Heusler-Struktur aufweist.

3. Thermoelektrischer Gegenstand nach Anspruch 2, wobei die Phase mit der Halb-Heusler-Struktur jeweils weniger als 0,2 Atom-% an einem oder beiden der Elemente A und B aufweist.

4. Thermoelektrischer Gegenstand nach Anspruch 2 oder Anspruch 3, wobei die Zusammensetzung der Phasen mit der Halb-Heusler-Struktur durch die Summenformel Ti*ₐ*Zr_{1-*a*}NiSnr*_{1-b}*Sb*_{b}* gegeben ist, wobei 0 < *a* ≤ 1 und 0 ≤ *b* ≤ 0,1.

5. Verbundmaterial für eine thermoelektrische Umwandlungsvorrichtung aufweisend:
eine Matrix mit zumindest einer Phase mit einer Halb-Heusler-Struktur auf αNiβ - Basis, wobei α Ti und Zr und optional Hf ist, und β zumindest eines der Elemente der Gruppe bestehend aus Sn und Sb ist, wobei der Anteil an Hf weniger als 1,7 Atom-% ist,
Einschlüsse aus einer A- reichen Phase, wobei A eines oder mehrere der Elemente ausgewählt aus der Gruppe bestehend aus Sc, Y und La ist, und/oder
Einschlüsse aus einer B-reichen Phase, wobei B eines oder mehrere der Elemente ausgewählt aus der Gruppe bestehend aus V, Nb und Ta ist, und
ein Maximum der thermoelektrischen Gütezahl ZTₘₐₓ von ≥ 0,8,
eine Gesamtzusammensetzung bestehend aus
6 Atom-% ≤ Ti ≤ 27 Atom-%,
6 Atom-% ≤ Zr ≤ 27 Atom-%,
0 Atom-% ≤ Hf ≤ 1,7 Atom-%,
wobei 28 Atom-% ≤ (Ti + Zr + Hf) ≤ 38 Atom-% ist,
28 Atom-% ≤ Sn ≤ 38 Atom-%,
0 Atom-% ≤ Sb ≤ 3 Atom-%,
wobei 28 Atom-% ≤ (Sn + Sb) ≤ 38 Atom-% ist,
0 Atom-% ≤ A ≤ 7 Atom-%,
0 Atom-% ≤ B ≤ 7 Atom-%, wobei A eines oder mehrere der Elemente ausgewählt aus der Gruppe bestehenden aus Sc, Y und La ist, B eines oder mehrere der Elemente ausgewählt aus der Gruppe bestehend aus V, Nb und Ta ist, und 0,15 Atom-% ≤ A+B ≤ 7 Atom-% ist,
Rest Ni sowie bis zu 5 Atom-% Verunreinigungen.

6. Verbundmaterial nach Anspruch 5, wobei die Zusammensetzung der Phasen mit der Halb-Heusler-Struktur durch die Summenformel Ti*ₐ*Zr_{1-*a*}NiSn_{1-*b*}Sb*_{b}* gegeben ist, wobei 0 < a ≤1 und 0 ≤ *b* ≤ 0,1.

7. Verbundmaterial nach Anspruch 5 oder Anspruch 6, wobei die Matrix weniger als jeweils 0,2 Atom-% an einem oder mehreren der Elemente A und B aufweist.

8. Verbundmaterial nach einem der Ansprüche 5 bis 7, wobei die Einschlüsse aus einer A-reichen Phase und die Einschlüsse aus einer B-reichen Phase keine Halb-Heusler-Struktur aufweisen und/oder das Verbundmaterial bis zu 10 Vol% der A-reichen Phase und der B-reichen Phase aufweist.

9. Verfahren zum Herstellen eines thermoelektrischen Gegenstands für eine thermoelektrische Umwandlungsvorrichtung, umfassend:
Bereitstellen eines Ausgangsmaterials, das aus
6 Atom-% ≤ Ti ≤ 27 Atom-%,
6 Atom-% ≤ Zr ≤ 27 Atom-%,
0 Atom-% ≤ Hf ≤ 1,7 Atom-%, wobei 28 Atom-% ≤ (Ti + Zr + Hf) ≤ 38 Atom-% ist,
28 Atom-% ≤ Sn ≤ 38 Atom-%,
0 Atom-% ≤ Sb ≤ 3 Atom-%, wobei 28 Atom-% ≤ (Sn + Sb) ≤ 38 Atom-% ist,
0 Atom-% ≤ A ≤ 7 Atom-%,
0 Atom-% ≤ B ≤ 7 Atom-%, wobei A eines oder mehrere der Elemente ausgewählt aus der Gruppe bestehend aus Sc, Y und La ist, B eines oder mehrere der Elemente ausgewählt aus der Gruppe bestehend aus V, Nb und Ta ist, und 0,15 Atom-% ≤ A+B ≤ 7 Atom-% ist,
Rest Ni sowie bis zu 5 Atom-% Verunreinigungen besteht,
Erschmelzen des Ausgangsmaterials und anschließendes Erstarren, um mindestens einen Block zu formen,
Homogenisieren des Blocks bei einer Temperatur von 900°C bis 1200°C für eine Zeitdauer t, wobei 0,5 h ≤ t ≤ 100 h, um einen homogenisierten Block herzustellen,
Zerkleinern des homogenisierten Blocks,
Mahlen des zerkleinerten Blocks, wobei ein Pulver geformt wird,
Kaltpressen des Pulvers, wobei ein Grünkörper geformt wird,
Sintern des Grünkörpers unter einem Druck vom maximal 1 MPa bei einer Temperatur von 1000°C bis 1500°C für 0,5 h bis 24h, wobei ein thermoelektrischer Gegenstand hergestellt wird.

10. Verfahren nach Anspruch 9, wobei der Block zu einem groben Pulver zerkleinert, das grobe Pulver mit einem weiteren Mahlverfahren zu einem feinen Pulver gemahlen und das feine Pulver kaltgepresst wird.

11. Verfahren nach Anspruch 9 oder Anspruch 10, wobei das Ausgangsmaterial mittels Vakuum-Induktions-Schmelzen erschmolzen wird.

12. Verfahren nach einem der Ansprüche 9 bis 11, wobei der Block bei einer Temperatur von 1050°C bis 1180°C für eine Zeitdauer t, wobei 16 h ≤ t ≤ 36h, homogenisiert wird.

13. Verfahren zum Herstellen eines thermoelektrischen Gegenstands, das Folgendes aufweist:
Bereitstellen eines ersten Pulvers, das 6 Atom-% ≤ Ti ≤ 27 Atom-%, 6 Atom-% ≤ Zr ≤ 27 Atom-%, 0 Atom-% ≤ Hf ≤ 1,7 Atom-%, wobei 28 Atom-% ≤ (Ti + Zr + Hf) ≤ 38 Atom-% ist, 28 Atom-% ≤ Sn ≤ 38 Atom-%, 0 Atom-% ≤ Sb ≤ 3 Atom-%, 28 Atom-% ≤ (Sn + Sb) ≤ 38 Atom-%, Rest Ni sowie bis zu 5 Atom% Verunreinigungen besteht, wobei der Anteil an Elemente der Gruppen A und B weniger als 0,2 Atom-% beträgt,
Bereitstellen eines zweiten Pulvers, das 0 Atom-% ≤ A ≤ 7 Atom-% und/oder 0 Atom-% ≤ B ≤ 7 Atom-% aufweist, wobei A eines oder mehrere der Elemente ausgewählt aus der Gruppe bestehend aus Sc, Y und La ist, B eines oder mehrere der Elemente ausgewählt aus der Gruppe bestehend aus V, Nb und Ta ist, und 0,5 Atom-% ≤ A+B ≤ 7 Atom-% ist,
Mischen des ersten Pulvers und des zweiten Pulvers, wodurch ein Ausgangspulver erzeugt wird,
Kaltpressen des Ausgangspulvers, wobei ein Grünkörper geformt wird,
Sintern des Grünkörpers unter einem Druck vom maximal 1 MPa bei einer Temperatur von 1000°C bis 1500°C für 0,5 h bis 24h, wobei ein thermoelektrischer Gegenstand hergestellt wird.

14. Verfahren nach einem der Ansprüche 9 bis 13, wobei der thermoelektrische Gegenstand mittels Säge- und/oder Schleifverfahren zu mehreren Arbeitskomponenten verarbeitet wird.

15. Verfahren nach Anspruch 13 oder Anspruch 14, wobei das zweite Pulver ferner 6 Atom-% ≤ Ti ≤ 27 Atom-%, 6 Atom-% ≤ Zr ≤ 27 Atom-%, 0 Atom-% ≤ Hf ≤ 1,7 Atom-%, wobei 28 Atom-% ≤ (Ti + Zr + Hf) ≤ 38 Atom-% ist, 28 Atom-% ≤ Sn ≤ 38 Atom-%, 0 Atom-% ≤ Sb ≤ 3 Atom-%, wobei 28 Atom-% ≤ (Sn + Sb) ≤ 38 Atom-% ist, Rest Ni sowie bis zu 5 Atom% Verunreinigungen aufweist.

## Claims

1. Thermoelectric article for a thermoelectric conversion device, having an overall composition consisting of
6 atomic % ≤ Ti ≤ 27 atomic %,
6 atomic % ≤ Zr ≤ 27 atomic %,
0 atomic % ≤ Hf ≤ 1.7 atomic %,
wherein 28 atomic % ≤ (Ti + Zr + Hf) ≤ 38 atomic %,
28 atomic % ≤ Sn ≤ 38 atomic %,
0 atomic % ≤ Sb ≤ 3 atomic %,
wherein 28 atomic % ≤ (Sn + Sb) ≤ 38 atomic %,
0 atomic % ≤ A ≤ 7 atomic %,
0 atomic % ≤ B ≤ 7 atomic %, wherein A is one or more of the elements selected from the group consisting of Sc, Y and La, B is one or more of the elements selected from the group consisting of V, Nb and Ta and 0.15 atomic % ≤ A+B ≤ 7 atomic %,
rest Ni and up to 5 atomic % impurities.

2. Thermoelectric article according to claim 1, wherein the thermoelectric article has at least one phase with a half-Heusler structure.

3. Thermoelectric article according to claim 2, wherein the phase with the half-Heusler structure has in each case less than 0.2 atomic % of one or both of the elements A and B.

4. Thermoelectric article according to claim 2 or 3, wherein the composition of the phases with the half-Heusler structure is given by the chemical formula T*ₐ*Zr*_{1- a}*NiSn*_{1-b}*Sb*_{b}*, wherein 0 < *a* ≤ 1 and 0 ≤ *b* ≤ 0.1.

5. Composite material for a thermoelectric conversion device, having
a matrix with at least one phase with a half-Heusler structure on αNiβ base, wherein α is Ti and Zr and optionally Hf and β is at least one element of the group consisting of Sn and Sb, wherein the amount of Hf is less than 1.7 atomic %,
inclusions from an A-rich phase, wherein A is one or more of the elements selected from the group consisting of Sc, Y and La, and/or
inclusions from a B-rich phase, wherein B is one or more of the elements selected from the group consisting of V, Nb and Ta, and
a maximum of the thermoelectric figure of merit ZTₘₐₓ of ≥ 0.8,
an overall composition consisting of
6 atomic % ≤ Ti ≤ 27 atomic %,
6 atomic % ≤ Zr ≤ 27 atomic %,
0 atomic % ≤ Hf ≤ 1.7 atomic %,
wherein 28 atomic % ≤ (Ti + Zr + Hf) ≤ 38 atomic %,
28 atomic % ≤ Sn ≤ 38 atomic %,
0 atomic % ≤ Sb ≤ 3 atomic %,
wherein 28 atomic % ≤ (Sn + Sb) ≤ 38 atomic %,
0 atomic % ≤ A ≤ 7 atomic %,
0 atomic % ≤ B ≤ 7 atomic %, wherein A is one or more of the elements selected from the group consisting of Sc, Y and La, B is one or more of the elements selected from the group consisting of V, Nb and Ta and 0.15 atomic % ≤ A+B ≤ 7 atomic %,
rest Ni and up to 5 atomic % impurities.

6. Composite material according to claim 5, wherein the composition of the phases with the half-Heusler structure is given by the chemical formula T*ₐ*Zr*₁₋ₐ*NiSn*_{1- b}*Sb*_{b}*, wherein 0 < *a* ≤ 1 and 0 ≤ *b* ≤ 0.1.

7. Composite material according to claim 5 or 6, wherein the matrix has less than 0.2 atomic % each of one or more of the elements A and B.

8. Composite material according to any of claims 5 to 7, wherein the inclusions from an A-rich phase and the inclusions from a B-rich phase do not have a half-Heusler structure and/or wherein the composite material has up to 10% by volume of the A-rich phase and the B-rich phase.

9. Method for producing a thermoelectric article for a thermoelectric conversion device, comprising:
the provision of a starting material consisting of
6 atomic % ≤ Ti ≤ 27 atomic %,
6 atomic % ≤ Zr ≤ 27 atomic %,
0 atomic % ≤ Hf ≤ 1.7 atomic %, wherein 28 atomic % ≤ (Ti + Zr + Hf) ≤ 38 atomic %,
28 atomic % ≤ Sn ≤ 38 atomic %,
0 atomic % ≤ Sb ≤ 3 atomic %, wherein 28 atomic % ≤ (Sn + Sb) ≤ 38 atomic %,
0 atomic % ≤ A ≤ 7 atomic %,
0 atomic % ≤ B ≤ 7 atomic %, wherein A is one or more of the elements selected from the group consisting of Sc, Y and La, B is one or more of the elements selected from the group consisting of V, Nb and Ta and 0.15 atomic % ≤ A+B ≤ 7 atomic %,
rest Ni and up to 5 atomic % impurities,
the melting of the starting material followed by solidifying to form at least one block,
the homogenising of the block at a temperature of 900°C to 1200°C for a duration t, wherein 0.5 h ≤ t ≤ 100 h, to produce a homogenised block,
the crushing of the homogenised block,
the grinding of the homogenised block while forming a powder,
the cold-pressing of the powder while forming a green body,
the sintering of the green body under a maximum pressure of 1 MPa at a temperature of 1000°C to 1500°C for 0.5 h to 24 h while producing a thermoelectric article.

10. Method according to claim 9, wherein the block is crushed to produce a coarse powder, the coarse powder is ground in a further grinding process to produce a fine powder and the fine powder is cold-pressed.

11. Method according to claim 9 or 10, wherein the starting material is melted by means of vacuum induction melting.

12. Method according to any of claims 9 to 11, wherein the block is homogenised at a temperature of 1050°C to 1180°C for a duration t, wherein 16 h ≤ t ≤ 36 h.

13. Method for producing a thermoelectric article, the method comprising the following:
the provision of a first powder consisting of 6 atomic % ≤ Ti ≤ 27 atomic %, 6 atomic % ≤ Zr ≤ 27 atomic %, 0 atomic % ≤ Hf ≤ 1.7 atomic %, wherein 28 atomic % ≤ (Ti + Zr + Hf) ≤ 38 atomic %, 28 atomic % ≤ Sn ≤ 38 atomic %, 0 atomic % ≤ Sb ≤ 3 atomic %, wherein 28 atomic % ≤ (Sn + Sb) ≤ 38 atomic %, rest Ni and up to 5 atomic % impurities, wherein the proportion of elements of the groups A and B is less than 0.2 atomic %,
the provision of a second powder containing 0 atomic % ≤ A ≤ 7 atomic % and/or 0 atomic % ≤ B ≤ 7 atomic %, wherein A is one or more of the elements selected from the group consisting of Sc, Y and La, B is one or more of the elements selected from the group consisting of V, Nb and Ta and 0.5 atomic % ≤ A+B ≤ 7 atomic %,
the mixing of the first powder and the second powder, thereby producing a starting powder,
the cold-pressing of the starting powder while forming a green body,
the sintering of the green body under a maximum pressure of 1 MPa at a temperature of 1000°C to 1500°C for 0.5 h to 24 h while producing a thermoelectric article.

14. Method according to any of claims 9 to 13, wherein the thermoelectric article is processed by means of a sawing and/or grinding process to produce several working components.

15. Method according to claim 13 or 14, wherein further comprises 6 atomic % ≤ Ti ≤ 27 atomic %, 6 atomic % ≤ Zr ≤ 27 atomic %, 0 atomic % ≤ Hf ≤ 1.7 atomic %, wherein 28 atomic % ≤ (Ti + Zr + Hf) ≤ 38 atomic %, 28 atomic % ≤ Sn ≤ 38 atomic %, 0 atomic % ≤ Sb ≤ 3 atomic %, wherein 28 atomic % ≤ (Sn + Sb) ≤ 38 atomic %, rest Ni and up to 5 atomic % impurities.

## Revendications

1. Objet thermoélectrique pour un dispositif de transformation thermoélectrique comprenant une composition totale constituée de :
6 en pourcentage atomique ≤ Ti ≤ 27 en pourcentage atomique
6 en pourcentage atomique ≤ Zr ≤ 27 en pourcentage atomique
0 en pourcentage atomique ≤ Hf ≤ 1,7 en pourcentage atomique
28 en pourcentage atomique ≤ (Ti + Zr + Hf) ≤ 38 en pourcentage atomique
28 en pourcentage atomique ≤ Sn ≤ 38 en pourcentage atomique
0 en pourcentage atomique ≤ Sb ≤ 3 en pourcentage atomique
28 en pourcentage atomique ≤ (Sn + Sb) ≤ 38 en pourcentage atomique
0 en pourcentage atomique ≤ A ≤ 7 en pourcentage atomique
0 en pourcentage atomique ≤ B ≤ 7 en pourcentage atomique, A étant au moins un élément sélectionné dans le groupe constitué de Sc, Y et La, B étant au moins un élément sélectionné dans le groupe constitué de V, Nb et Ta et 0,15 en pourcentage atomique ≤ A + B ≤ 7 en pourcentage atomique,
le reste étant Ni ainsi que jusqu'à 5 en pourcentage atomique d'impuretés.

2. Objet thermoélectrique selon la revendication 1, l'objet thermoélectrique présentant au moins une phase avec une structure semi-Heusler.

3. Objet thermoélectrique selon la revendication 2, la phase avec la structure semi-Heusler présentant respectivement moins de 0,2 en pourcentage atomique d'un ou des deux éléments A et B.

4. Objet thermoélectrique selon la revendication 2 ou la revendication 3, la composition des phases avec la structure semi-Heusler est indiquée par la formule moléculaire TiₐZr₁₋ₐNiSn_{1-b}SB_{b}, 0 < a ≤ 1 et 0 ≤ b ≤ 0,1.

5. Matériau composite pour un dispositif de transformation thermoélectrique présentant :
une matrice comprenant au moins une phase avec une structure semi-Heusler sur la base de α Niβ, α étant Ti et Zr et Hf en option, et β étant au moins l'un des éléments du groupe constitué de Sn et Sb, la proportion de Hf étant inférieure à 1,7 en pourcentage atomique,
des inclusions provenant d'une phase riche en A, A d'un ou plusieurs éléments étant sélectionné à partir du groupe constitué de Sc, Y et La, et/ou
des inclusions provenant d'une phase riche en B, B d'un ou plusieurs éléments étant sélectionné à partir du groupe constitué de V, Nb et Ta, et
un maximum de l'indice de qualité thermoélectrique ZTₘₐₓ ≥ 0,8,
une composition totale constituée de
6 en pourcentage atomique ≤ Ti ≤ 27 en pourcentage atomique
6 en pourcentage atomique ≤ Zr ≤ 27 en pourcentage atomique
0 en pourcentage atomique ≤ Hf ≤ 1,7 en pourcentage atomique
28 en pourcentage atomique ≤ (Ti + Zr + Hf) ≤ 38 en pourcentage atomique
28 en pourcentage atomique ≤ Sn ≤ 38 en pourcentage atomique
0 en pourcentage atomique ≤ Sb ≤ 3 en pourcentage atomique
28 en pourcentage atomique étant ≤ (Sn + Sb) ≤ 38 en pourcentage atomique
0 en pourcentage atomique ≤ A ≤ 7 en pourcentage atomique
0 en pourcentage atomique ≤ B ≤ 7 en pourcentage atomique, A étant au moins un élément sélectionné dans le groupe constitué de Sc, Y et La, B étant au moins un élément sélectionné dans le groupe constitué de V, Nb et Ta et 0,15 en pourcentage atomique ≤ A + B ≤ 7 en pourcentage atomique,
le reste étant Ni ainsi que jusqu'à 5 en pourcentage atomique d'impuretés.

6. Matériau composite selon la revendication 5, la composition de la phase avec la structure semi-Heusler étant indiquée par la formule par la formule moléculaire TiₐZr₁₋ₐNiSn_{1-b}SB_{b}, 0 < a ≤ 1 et 0 ≤ b ≤ 0,1.

7. Matériau composite selon la revendication 5 ou la revendication 6, la matrice présentant respectivement moins de 0,2 en pourcentage atomique d'un ou de plusieurs des éléments A et B.

8. Matériau composite selon l'une quelconque des revendications 5 à 7, les inclusions provenant d'une phase riche en A et les inclusions provenant d'une phase riche en B ne présentant pas de structure semi-Heusler et/ou le matériau composite présentant jusqu'à 10 en pourcentage atomique de la phase riche en A et de la phase riche en B.

9. Procédé de fabrication d'un objet thermoélectrique pour un dispositif de transformation thermoélectrique, consistant à :
préparer un produit de base qui est constitué de
6 en pourcentage atomique ≤ Ti ≤ 27 en pourcentage atomique
6 en pourcentage atomique ≤ Zr ≤ 27 en pourcentage atomique
0 en pourcentage atomique ≤ Hf ≤ 1,7 en pourcentage atomique, 28 en pourcentage atomique étant ≤ (Ti + Zr + Hf) ≤ 38 en pourcentage atomique
28 en pourcentage atomique ≤ Sn ≤ 38 en pourcentage atomique
0 en pourcentage atomique ≤ Sb ≤ 3 en pourcentage atomique, 28 en pourcentage atomique étant ≤ (Sn + Sb) ≤ 38 en pourcentage atomique
0 en pourcentage atomique ≤ A ≤ 7 en pourcentage atomique
0 en pourcentage atomique ≤ B ≤ 7 en pourcentage atomique, A étant un ou plusieurs des éléments sélectionnés dans le groupe constitué de Sc, Y et La, B étant au moins un élément sélectionné dans le groupe constitué de V, Nb et Ta et 0,15 en pourcentage atomique ≤ A + B ≤ 7 en pourcentage atomique,
le reste étant Ni ainsi que jusqu'à 5 en pourcentage atomique d'impuretés,
élaborer le produit de base et solidifier ensuite pour obtenir au moins un bloc
homogénéiser le bloc à une température comprise entre 900°C et 1 200°C pour une durée t, 0,5 h ≤ t ≤ 100 h, pour fabriquer un bloc homogénéisé,
concasser le bloc homogénéisé
broyer le bloc concassé pour obtenir une poudre
presser à froid la poudre pour obtenir un corps cru
fritter le corps cru à une pression de 1 MPA maximum à une température comprise entre 1 000°C et 1 500°C pendant entre 0,5 h et 24 h, pour obtenir ainsi un objet thermoélectrique.

10. Procédé selon la revendication 9, le bloc est concassé en une poudre grossière, ladite poudre grossière est ensuite broyée selon un autre procédé de broyage en une poudre fine et ladite poudre fine est pressée à froid.

11. Procédé selon la revendication 9 ou la revendication 10, le produit de base étant élaboré au moyen d'une élaboration par induction à vide.

12. Procédé selon l'une quelconque des revendications 9 à 11, le bloc étant homogénéisé à une température comprise entre 1 050°C et 1 180°C pendant une durée t, 16 h ≤ t ≤ 36 h.

13. Procédé de fabrication d'un objet thermoélectrique, comprenant les étapes suivantes consistant à :
préparer une première poudre qui est constituée de 6 en pourcentage atomique ≤ Ti ≤ 27 en pourcentage atomique, 6 en pourcentage atomique ≤ Zr ≤ 27 en pourcentage atomique, 0 en pourcentage atomique ≤ Hf ≤ 1,7 en pourcentage atomique, 28 en pourcentage atomique ≤ (Ti + Zr + Hf) ≤ 38 en pourcentage atomique, 28 en pourcentage atomique ≤ Sn ≤ 38 en pourcentage atomique, 0 en pourcentage atomique ≤ Sb ≤ 3 en pourcentage atomique, 28 en pourcentage atomique ≤ (Sn + Sb) ≤ 38 en pourcentage atomique, le reste étant du Ni ainsi que jusqu'à 5 en pourcentage atomique d'impuretés, la proportion des éléments des groupes A et B s'élevant à moins de 0,2 en pourcentage atomique,
préparer une seconde poudre qui est constituée de 0 en pourcentage atomique ≤ A ≤ 7 en pourcentage atomique et/ou 0 en pourcentage atomique ≤ B ≤ 7 en pourcentage atomique, A étant un ou plusieurs des éléments sélectionnés dans le groupe constitué de Sc, Y et La, B étant au moins un élément sélectionné dans le groupe constitué de V, Nb et Ta et 0,5 en pourcentage atomique ≤ A + B ≤ 7 en pourcentage atomique,
mélanger la première poudre et la seconde poudre, pour obtenir une poudre de base
presser à froid la poudre de base, pour obtenir un corps cru,
fritter le corps cru à une pression de 1 MPA maximum à une température comprise entre 1 000°C et 1 500°C pendant 0,5 h et jusqu'à 24 h, pour fabriquer un objet thermoélectrique.

14. Procédé selon l'une quelconque des revendications 9 à 13 l'objet thermoélectrique étant usiné selon un procédé de sciage et/ou de meulage pour obtenir plusieurs composants de travail.

15. Procédé selon la revendication 13 ou la revendication 14, la seconde poudre présentant en outre de 6 en pourcentage atomique ≤ Ti ≤ 27 en pourcentage atomique, 6 en pourcentage atomique ≤ Zr ≤ 27 en pourcentage atomique, 0 en pourcentage atomique ≤ Hf ≤ 1,7 en pourcentage atomique, 28 en pourcentage atomique ≤ (Ti + Zr + Hf) ≤ 38 en pourcentage atomique, 28 en pourcentage atomique ≤ Sn ≤ 38 en pourcentage atomique, 0 en pourcentage atomique ≤ Sb ≤ 3 en pourcentage atomique, 28 en pourcentage atomique ≤ (Sn + Sb) ≤ 38 en pourcentage atomique, le reste étant Ni ainsi que jusqu'à 5 en pourcentage atomique d'impuretés.
